Europäisches Patentamt

European Patent Office

Office européen des brevets

(11) Veröffentlichungsnummer: **0 082 493**
A2

# (12) EUROPÄISCHE PATENTANMELDUNG

(21) Anmeldenummer: 82111695.1

(22) Anmeldetag: 16.12.82

(51) Int. Cl.³: **H 03 K 17/08**

(30) Priorität: 21.12.81 DE 3150703

(43) Veröffentlichungstag der Anmeldung:
29.06.83 Patentblatt 83/26

(84) Benannte Vertragsstaaten:
AT BE CH FR GB IT LI NL SE

(71) Anmelder: BROWN, BOVERI & CIE Aktiengesellschaft
Kallstadter Strasse 1
D-6800 Mannheim 31(DE)

(72) Erfinder: Claussen, Claus-Jürgen, Ing. (grad.)
Riedwiesenweg 10
D-6906 Leimen(DE)

(74) Vertreter: Kempe, Wolfgang, Dr. et al,
c/o Brown, Boveri & Cie AG Postfach 351
D-6800 Mannheim 1(DE)

(54) **Ansteuerschaltung für kurzschlussfeste Ausgabestufen.**

(57) Durch den Einsatz von drei Schmitt-Triggern (SMT1, SMT2, SMT3) mit unterschiedlichen Ansprechschwellen, die von einem externen Kondensator gesteuert werden, sowie drei Komparatoren (1, 2, 3), Verknüpfungsgliedern (4, 5, 7) und Transistorstufen (T1, T2) kann die Ansteuerschaltung eine externe Leistungsstufe (T3) ansteuern, den Strom überwachen und im Kurzschluß- oder Überlastfall alle gefährdeten Bauelemente schützen. Ferner werden alle Störungsfälle gespeichert. Im Überlastfall, bei der die Endstufe (T3) zunächst in Strombegrenzung ist, werden bei Dauerquittierung zyklische Zuschaltversuche vorgenommen.

BROWN, BOVERI & CIE AKTIENGESELLSCHAFT
Mannheim                                    16. Dez. 1981
Mp.-Nr. 705/81                              ZPT/P3-NL/Bt

## Ansteuerschaltung für kurzschlußfeste Ausgabestufen

Die Erfindung bezieht sich auf eine Ansteuerschaltung
für kurzschlußfeste Ausgabestufen mit mehreren schutzbeschalteten Ein- und Ausgängen und liegt auf dem Gebiet
der elektronischen Steuerungstechnik.

Das Ansteuern von Lampen, Relais, Schützen und Magnetventilen durch elektronische Steuer-, Regel- und Datenverarbeitungsanlagen erfordert den Einsatz robuster,
kurzschluß- und überlastsicherer, universell einsetzbarer, kostengünstiger Leistungsstufen.

Aus der DE-OS 28 25 752 ist eine Schaltungsanordnung für
einen universellen, integrierten, kurzschlußfesten Leistungsschaltkreis mit mehreren schutzbeschalteten Eingängen für binäre Eingangssignale und mehreren schutzbeschalteten Ausgängen bekannt. Durch ein integriertes
Leistungsteil kann dieser Schaltkreis neben Lampen die
unterschiedlichsten Arten von Transistorstufen ansteuern, der Schaltkreis kann an einem Ausgang auf Kurzschluß und Drahtbruch überwacht werden und alle Fehl-

705/81          2      **0082493**

ströme gegen Masse und Speisespannung anzeigen. Dieser Schaltkreis ist zwar universell einsetzbar, durch sein Leistungsteil aber wärmeempfindlich und für spezielle Schaltungsaufgaben nicht immer verwendbar.

Aus einem Prospekt der Fa. Thomson-CSF über "Circuit de interface TDE 1767 et 1787" sind integrierte Schaltkreise für Relais- und Lampentreiber bekannt. Der Leistungstransistor (Ausgabestufe) ist hierbei mitintegriert. Im Kurzschluß- oder Überlastfall schaltet dabei der Baustein den Laststrom ab und überprüft periodisch, ob der zu hohe Strom noch besteht. Der erhöhte Strom wird über einen externen Meßwiderstand festgestellt. Dieser Schaltkreis ist zwar sehr kompakt aufgebaut und bietet dem Anwender im Normalfall eine große Einsatzmöglichkeit, doch sind bei Spezialfällen keine Anwendungsmöglichkeiten gegeben. Dieser Baustein wird nach den Richtlinien des entsprechenden Datenblattes eingesetzt und ist dadurch im Einsatz begrenzt. Nachteilig ist weiter, daß durch die ebenfalls mitintegrierte Endstufe eine zusätzliche thermische Belastung auftritt. Dieser Schaltkreis ist zwar für viele Fälle einsetzbar, er ist aber nicht universell verwendbar und nicht für Spezialaufgaben erweiterbar.

Es ist deshalb Aufgabe der Erfindung, eine Ansteuerschaltung für kurzschlußfeste Ausgabestufen zu finden, die für viele einfache Anwendungsfälle ausreicht, aber für spezielle Fälle auf Wunsch in vielen Richtungen erweiterbar und anpassungsfähig ist. Mit der erfindungsgemäßen Ansteuerschaltung soll weiterhin ein Leistungstransistor extern zuschaltbar sein, so daß an dieser Stelle verschiedene auf dem Markt erhältliche Leistungstransistoren einsetzbar sind.

Erfindungsgemäß wird dies durch das Kennzeichen des Patentanspruchs erzielt.

Vorteilhaft bei der erfindungsgemäßen Ansteuerschaltung ist besonders der universelle Einsatz selbst bei Spezialaufgaben. Durch den nur scheinbaren Nachteil der externen zuschaltbaren Leistungsstufe konnte erreicht werden, daß der Schaltkreis in seinen Grundfunktionen einfach und billig aufgebaut ist und trotzdem die übliche Anwendungsbreite erfüllt, aber durch zusätzliche unterschiedliche Beschaltungsmöglichkeiten und den großen Projektierungsspielraum sehr anwenderfreundlich und komfortabel einsetzbar ist. So können beispielsweise Ausgabestufen für jede beliebige Stromstärke angesteuert werden.

Da die erfindungsgemäße Ansteuerschaltung in integrierter Technik aufgebaut ist, konnte eine zusätzliche baugleiche Ansteuerschaltung als weitere Funktionseinheit in einem genormten Dual-in-Line-Gehäuse untergebracht werden. Ein integrierter Schaltkreis besteht also aus dem zweimaligen Einsatz der erfindungsgemäßen Schaltungsanordnung und einem gemeinsamen Versorgungsteil. Durch die Herausnahme des kostenmäßig sehr aufwendigen Leistungsteils aus dem integrierten Schaltkreis treten keine Wärmeprobleme mehr auf und die Betriebsdaten verbessern sich erheblich.

Die erfindungsgemäße Ansteuerschaltung verhindert bei Kurzschluß am Ausgang oder niederohmiger Last ein Zerstören der externen Endstufe oder des Schaltkreises. Die erfindungsgemäße Schaltung bereitet ferner das Eingangssignal zur Ansteuerung der Endstufe auf und überwacht die Endstufe im Kurzschluß- und Überlastfall. Der Störfall der Überlastung kann gespeichert und gemeldet werden. Über einen Quittier-(Lösch)-eingang ist die Speicherung rücksetzbar. Durch ein positives Quittiersignal am Quittier-(Lösch)-eingang kann die Endstufe wieder zugeschaltet werden. Die Ab- und Zuschaltbedingungen bei irgendwelchen Störfällen sind zusätzlich verzögerbar, so daß kurzfristige Überlastungen, z.B. ein Einschaltstromstoß, nicht zur Abschaltung führen. In vorteilhafter Weise wird während dieser Überlastungsphase in der erfindungsgemäßen Ansteuerschaltung eine Strombegrenzung vorgenommen.

Nach einer Abschaltung ist in der Regel eine Pause zur Erholung (thermische Erholzeit) der beanspruchten Bauelemente erforderlich. Die Abschaltverzögerung, die Pausendauer und auch das Quittiersignal werden dabei mit einem einzigen extern zuschaltbaren Kondensator in ihrer Größe bestimmt. Das Löschen im Kurzschluß- oder Überlastfall kann erst erfolgen, wenn die thermische Erholzeit der Bauelemente beendet ist. Diese Zeit wird durch Entladen des externen Kondensators realisiert. Sämtliche Zeitbedingungen von der Störmeldung bis zur Rückschaltung werden in vorteilhafter Weise nur durch den einen externen Kondensator in Verbindung mit drei Schmitt-Triggern gelöst.

Weitere Vorteile sind aus der nachfolgenden Beschreibung ersichtlich.

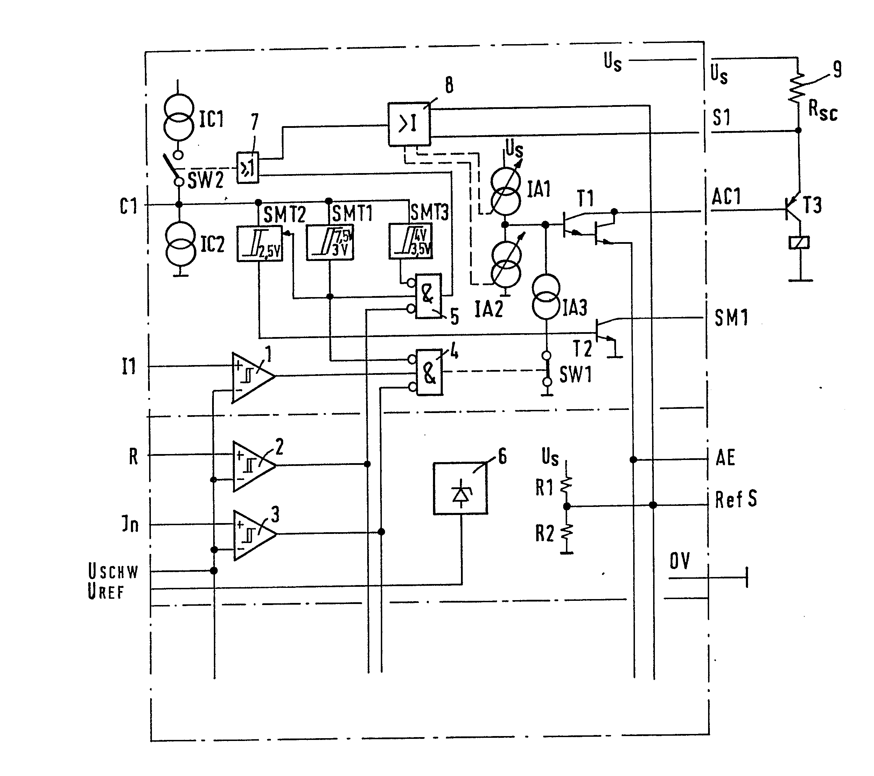

Ein Ausführungsbeispiel der erfindungsgemäßen Ansteuerschaltung wird nachstehend anhand der Zeichnung näher erläutert.

Die erfindungsgemäße Ansteuerschaltung ist als Funktionseinheit in einem robusten, bipolaren Treiberschaltkreis (RBT) in integrierter Technik ausgeführt. Innerhalb dieses integrierten Schaltkreises ist die Funktionseinheit zweimal vorhanden. Der RBT besteht folglich aus zwei gleichen Funktionseinheiten und einem gemein-

705/81  5  0082493

samen Teil.

Zur Vereinfachung wurde in der Zeichnung des Ausführungsbeispiels die zweite Funktionseinheit nur andeutungsweise dargestellt.

Die erfindungsgemäße Ansteuerschaltung weist die Eingänge I1, R (Reset), In (Inhibit) und $U_{SCHW}$ auf. Die Ausgänge sind mit $U_{REF}$, AC1, SM1 und AE bezeichnet. Zur Überwachung des Laststromes dienen die Anschlüsse S1 und RefS. An den C1-Anschluß kann ein Kondensator zugeschaltet werden. Die Spannungsversorgung ist auf die Anschlüsse $U_S$ und 0V gelegt. An die Ein- und Ausgänge geschaltete Schutzdioden, die Störpotentiale im praktischen Einsatz ableiten sollen, sind der Übersicht halber in der Zeichnung nicht dargestellt. An die Ausgänge S1 und AC1 sind symbolhaft ein Strommeßwiderstand 9 und ein Leistungstransistor T3 mit einem Relais als Last im Kollektorzweig geschaltet.

Die Eingänge I1, R und In sind jeweils auf die Plus-Eingänge von Komparatoren 1, 2, 3 geführt. Der Minus-Eingang der Komparatoren 1, 2, 3 ist gemeinsam auf die Eingangsklemme $U_{SCHW}$ gelegt. Mit einer über diese Klemme extern zugeführten Schwellenspannung wird die Schaltschwelle der Komparatoren festgelegt.

Dem Signaleingang I1 ist der Komparator 1, dem Eingang R (Reset = Rücksetz- Quittier- oder Löscheingang) der Komparator 2 und dem Eingang In (Inhibit = Verhinderung) der Komparator 3 nachgeschaltet. Der Eingang In dient dabei zur vorrangigen Abschaltung aller Signalkanäle. Alle drei Eingänge I1, R und In reagieren aktiv auf ein 1-Signal. Die drei Komparatoren 1, 2, 3 besitzen ein Schmitt-Trigger-Verhalten, d.h., sie weisen feste Schaltschwellen mit Hysterese auf.

Eine interne Spannungsquelle 6 ist vorgesehen zur Bildung einer Referenzspannung für den Ausgang $U_{REF}$. Diese Referenzspannung am Ausgang $U_{REF}$ wird aus der Speisespannung am Anschluß $U_S$ gebildet, beispielsweise über eine Zenerdiode, und kann über eine Drahtbrücke auf den Eingang $U_{SCHW}$ geführt werden.

Die Ausgänge der Komparatoren 1 und 3 sind auf ein UND-Glied 4 mit Sperreingängen geführt. Der Komparator 1 ist dabei auf den wahren und der Komparator 3 auf einen inversen Eingang des UND-Gliedes gelegt. Der Ausgang des Komparators 2 ist auf den einen inversen Eingang eines weiteren UND-Gliedes 5 geschaltet. An den C1-Anschluß (externer Kondensator) sind die Eingänge von drei Schmitt-Triggern SMT1, SMT2 und SMT3 angeschaltet. Diese Schmitt-Trigger weisen jeweils unterschiedliche Schaltschwellen auf. Der Ausgang des Schmitt-Triggers SMT1 ist einmal auf den Setzeingang des Schmitt-Triggers SMT2 (SMT2 hat keine obere Schaltschwelle, sondern wird über einen Setzeingang wie ein Speicher gesetzt), einmal auf den wahren Eingang des UND-Gliedes 5 und einmal auf den inversen Eingang des UND-Gliedes 4 geführt. Der Ausgang des Schmitt-Triggers SMT2 ist über eine Transistorstufe T2 auf den Störmeldeausgang SM1 gelegt. Der Ausgang des Schmitt-Triggers SMT3 ist mit einem inversen Eingang des UND-Gliedes 5 verbunden. An die Eingänge der Schmitt-Trigger SMT1, SMT2, SMT3 ist noch eine Stromsenke IC2 und über einen Schalter SW2 die Stromquelle IC1 geschaltet. Dabei wird der Schalter SW2 von einem ODER-Glied 7 angesteuert, von dem ein Eingang mit dem Ausgang des UND-Gliedes 5 verbunden ist.

Der Ausgang des UND-Gliedes 4 steuert einen Schalter SW1 an, der eine Stromquelle IA3 an Minus-Potential legt. Die Stromquelle ist mit ihrer positiven Seite auf die Basis eines Darlington-Transistors T1 gelegt. Weiterhin ist die Stromquelle einmal an eine auf Minus-Potential gelegte Stromquelle IA2 und einmal an eine auf Betriebsspannung $U_S$ gelegte Stromquelle IA1 geführt. Beide Stromquellen IA1 und IA2 werden von einer Auswerteschaltung 8 geregelt. Diese ist im Normalfall passiv, während im sie Überlastfall IA1 und IA2 beeinflußt und das ODER-Glied 7 mit 1-Signal ansteuert.

Die Darlington-Stufe T1, die an ihrer Basis von den Stromquellen IA1, IA2, IA3 angesteuert wird, ist mit ihrem Kollektor auf den Leistungsausgang AC1 geführt. Durch diesen Ausgang kann der nachgeschaltete Leistungstransistor T3 angesteuert werden. Der Emitter der Darlington-Stufe T1 ist auf den Ausgang AE geführt. Durch diese Anschlußklemme AE wird die Emitter-Spannungsversorgung für die Darlington-Stufe T1 vorgenommen (eventuell Emitter hochlegen - Einsparung von Verlustleistung).

Zur Auswertung erhöhter Ströme im Kurzschluß- oder Überlastfall ist die Auswerteschaltung 8 vorgesehen. Diese vergleicht die durch die Spannungsteilerwiderstände R1,R2 gewonnene Referenzspannung RefS mit dem über Anschluß S1 zugeführten Spannungsabfall des externen, im Laststromkreis befindlichen Strommeßwiderstandes ($R_{SC}$)9. Die Eingänge der Auswerteschaltung sind deshalb mit den Anschlüssen RefS und S1 verbunden.

Die Auswerteschaltung 8 besteht beispielsweise aus einem Komparator. Sie führt, wenn an ihren Eingängen eine entsprechende Spannung anliegt, wichtige Handlungen aus. Einmal erfüllt sie die ODER-Bedingung des Gliedes 7, wodurch über die Stromquelle IC1 und den geschlossenen Schalter SW2 der extern an den Anschluß C1 geschaltete Kondensator aufgeladen wird. Dies geschieht beispielsweise, wenn ein zu hoher Laststrom fließt. Über die Stromquelle IC1 wird also der externe Kondensator aufgeladen und der Leistungsausgang AC1 nach einer Verzögerungszeit abgeschaltet. Die Stromsenke IC2 bestimmt die thermische Erholzeit bzw. die Pausendauer bei zyklischen Wiederzuschaltversuchen. Die Auswerteschaltung 8 beeinflußt zusätzlich noch über die Stromquelle IA1 und die Stromsenke IA2 den Basisstrom des Darlington-Transistors T1 so, daß die Transistoren T1 und T3 in die Strombegrenzung gehen. Der Strom von IA1 wird dabei geschwächt und der Strom von IA2 verstärkt. Dadurch kann die Basis regelungstechnisch sehr gut beherrscht werden.

Die erfindungsgemäße Ansteuerschaltung als Funktionseinheit konnte in vorteilhafter Weise auf dem integrierten Schaltkreis doppelt untergebracht werden. Auf der Zeichnung wurde die zweite, identische Ansteuerschaltung nur andeutungsweise dargestellt. Diese zweite Funktionseinheit (Ansteuerschaltung) ist mit der ersten bzw. dem gestrichelt umrandeten gemeinsamen Teil durch den Eingangsanschluß $U_{SCHW}$, durch den Ausgang des Komparators 2, den Ausgang des Komparators 3, den Spannungsversorgungsanschluß AE und durch den Anschluß RefS verbunden. $U_{REF}$ steht für beide Funktionseinheiten zur Verfügung.

Die erfindungsgemäße Ansteuerschaltung arbeitet wie folgt:
Der Signaleingang I1 ist zum Ansteuern des Ausgangs AC1 vorgesehen. Überschreitet eine Spannung (als 1-Signal) am Eingang I1 die am Anschluß $U_{SCHW}$ angelegte Referenzspannung um einen bestimmten Betrag, so spricht der Komparator 1 an und bringt den wahren Eingang des UND-Gliedes 4 auf 1-Potential (Voraussetzung: Eingang In ist mit 0-Signal beaufschlagt und der Schmitt-Trigger

SMT1 hat Ausgangs-0-Signal), das UND-Glied 4 ist durchgeschaltet und öffnet den Schalter SW1, so daß der Strom
aus der Stromquelle IA1 nicht mehr über IA3 gegen
Minus-Potential abgeleitet wird. IA1 steuert nun den
Darlington-Transistor T1 an, so daß dieser leitend wird
und den Ausgang AC1 durchschaltet. Über AC1 wird der
externe Leistungstransistor T3 angesteuert. Die Spannungsversorgung für den Emitter des Darlington-Transistors T1 wird über den Anschluß AE vorgenommen, d.h., AE
wird auf ein festes Potential gelegt.

Im Kurzschluß- oder Überlastfall zeigt die erfindungsgemäße Ansteuerschaltung folgendes Verhalten:
Ein zu hoher Laststrom hat einen erhöhten Spannungsabfall an dem Strommeßwiderstand 9 zur Folge. Dieser
erhöhte Spannungsabfall wird über den Stromfühlereingang
S1 der Auswerteschaltung 8 zugeführt und mit der Referenzspannung, gebildet aus den Widerständen R1 und R2,
an der Klemme RefS verglichen. Bei erhöhter Spannung an
der Klemme S1 wirkt die Auswerteschaltung 8 auf IA1
schwächend und IA2 stärkend, so daß es durch die verminderte Ansteuerung des Transistors T1 zu einer definierten Strombegrenzung für den Darlington-Transistor T1 und
den Leistungstransistor T3 kommt.

Die Auswerteschaltung 8 schließt bei überhöhtem Spannungsabfall am Anschluß S1 über das ODER-Glied 7 den
Schalter SW2. Die Stromquelle IC1 lädt nun einen am
Anschluß C1 angeschlossenen Kondensator auf. Das Abschalten einer an AC1 angeschalteten Leistungsstufe im
Überlastfall durch die erfindungsgemäße Ansteuerschaltung erfolgt dadurch, daß die Spannung aus dem extern
zugeschalteten Kondensator den Schmitt-Trigger SMT1
ansteuert, wenn dessen obere Schwelle (Schwellen beispielsweise von 3 und 7,5V) überschritten wird. Dann
wird 1-Signal auf das nachgeschaltete UND-Glied 4 gegeben (UND-Glied sperrt), wodurch das UND-Glied 4 über den geschlossenen Schalter SW1 und die Stromquelle IA3 den Darlington-Transistor T1 bzw. den Leistungsausgang AC1 sperrt. Mit dieser Abschaltung wird der Schalter SW2 über die Glieder 8 und 7 wieder geöffnet, denn es fließt ja nun kein überhöhter Laststrom mehr.

Der Schmitt-Trigger SMT1 gibt bei Erreichen der oberen Schaltschwelle (7,5V) gleichzeitig sein 1-Signal auf den Setzeingang des Schmitt-Triggers SMT2, so daß dieser ebenfalls durchschaltet. Nun wird der Transistor T2 leitend gesteuert, so daß am Ausgang SM1 eine Störmeldung (für Hupe, Lampe) ansteht.

Durch den geöffneten Schalter SW2 wird die weitere Aufladung des Kondensators an C1 verhindert. Stattdessen wird der Kondensator durch die Stromsenke IC2 wieder entladen. Diese Entladung muß langsam geschehen, weil der Leistungstransistor T3 während der Dauer der Strombegrenzung mit einer hohen Verlustleistung beansprucht wurde und nun eine große thermische Erholzeit benötigt. Unterschreitet die Kondensatorspannung den Wert 3V, d.h. die untere Schwelle am Schmitt-Trigger SMT1, wird der Signalweg über das UND-Glied 4 wieder freigegeben (UND-Glied 4 öffnet den Schalter SW1 und Stufe T1 schaltet wieder durch). Besteht die Überlastung noch, erfolgt kurz danach eine erneute Abschaltung. Diese zyklischen Zuschaltversuche (Takten) wiederholen sich solange, bis der Überlastfall beseitigt ist. Voraussetzung für die Zuschaltversuche ist, daß der Reset-Eingang R 1-Signal aufweist (Dauer-Quittierung). Während dieser Zuschaltversuche bleibt der Störmeldeausgang SM1 ununterbrochen leitend, da die untere Schaltschwelle von SMT2 (2,5V) nicht unterschritten wird.

Weist der Reset-Eingang R 0-Signal auf, schaltet beim Absinken der Kondensatorspannung auf 3,5V der Schmitt-Trigger SMT3 auf 0-Signal und bewirkt über das UND-Glied 5 und das ODER-Glied 7 ein erneutes Schließen des Schalters SW2 - also eine Kondensatorladung. Bei 4V-Kondensatorspannung wird die Ladung dann wieder abgebrochen, weil der Schmitt-Trigger SMT3 das UND-Glied 5 wieder sperrt. Dies bedeutet: Wenn der Schmitt-Trigger SMT1 wegen Überlastung des Ausgangs einmal auf 1-Signal geschaltet hat und wenn der Lösch-Eingang R 0-Signal aufweist, dann sorgt SMT3 mit seinen Schaltschwellen dafür, daß die Kondensatorspannung stets zwischen 3,5V und 4V schwankt und die untere Schaltschwelle von SMT1 nicht unterschritten wird. Eine Wiederzuschaltung kann somit nicht erfolgen, der Störungsfall bleibt gespeichert. Erst wenn das Bedienungspersonal eingreift und auf den Lösch-Eingang R 1-Signal gibt, wird über den Komparator 2 und das UND-Glied 5 0-Signal auf das ODER-Glied 7 gegeben. Hierdurch wird der Schalter SW2 geöffnet und der Kondensator an C1 kann sich über die Stromsenke IC2 entladen. Wenn die untere Schwelle (3V) des Schmitt-Triggers SMT1 unterschritten wird, wird über das UND-Glied 4, den Schalter SW 1 und den Darlington-Transistor T1 der Leistungsausgang AC1 wieder zugeschaltet.

Das Halten der Kondensatorspannung auf 3,5 bis 4V im gespeicherten Störungsfalle hat den Vorteil, daß bei Quittierung über den Eingang R eine Quittierverzögerung auftritt, die der Entladedauer des Kondensators von 3,5 bis 4V auf 3V entspricht und damit erheblich kürzer ist als die Pausendauer bzw. Erholzeit, die der Entladedauer von 7,5V auf 3V entspricht.

Zum praktischen Einsatzfall kann es notwendig sein, eine Erholzeit von z.B. 5 sec. zu fordern. Eine ebenso lange Quittierverzögerung wäre aber nicht tragbar, da sie unter Umständen das Bedienungspersonal irritieren würde, das mit einer sofortigen Reaktion auf das Quittieren rechnet.

Der am Anschluß C1 angeschlossene Kondensator ermöglicht als ein einziges Bauelement fünf unterschiedliche Verzögerungszeiten, die schaltkreisbedingt in festem Verhältnis zueinander stehen, und zwar:

1. Abschaltverzögerung der Leistungsstufe bei Auftreten eines Kurzschlusses oder einer Überlastung. Die Dauer dieser Verzögerung entspricht der Ladezeit des Kondensators bei geschlossenem Schalter SW2 durch die Stromquelle IC1 (abzüglich des Stromes durch IC2) zwischen Kondensatorspannungswerten von z.B. 0V und 7,5V (zuständig SMT1).

2. Erholzeit für den externen Leistungstransistor T3. Die Erholzeit ist die Wartezeit nach einer erfolgten Abschaltung wegen Kurzschluß oder Überlastung, in der unter keinen Umständen eine Wiederzuschaltung erfolgen kann und darf. Die Dauer der Erholzeit entspricht der Entladezeit des Kondensators an C1 durch die Stromsenke IC2 zwischen Kondensatorspannungswerten von z.B. 7,5V und 3V (zuständig SMT1).

Bei Dauerüberlastung und gleichzeitiger Dauerquittierung (Eingang R = 1-Signal) entspricht die Erholzeit der Pausendauer zwischen den Wiederzuschaltversuchen.

3. Impulsdauer der Wiederzuschaltversuche bei Dauerquittierung oder Handquittierung und nicht behobener Überlastung. Diese Impulsdauer entspricht der Ladezeit des Kondensators bei geschlossenem Schalter SW2 durch die Stromquelle IC1, abzüglich des Stromes IC2, zwischen Kondensatorspannungswerten von z.B. 3V und 7,5V (zuständig SMT1).

4.  Ansprechverzögerung des Quittiersignals bei Handquittierung. Dies ist der zeitliche Abstand vom
    0-1-Übergang am Eingang R bis zum Wiederzuschalten
    des Leistungsausgangs AC1. Die Dauer entspricht der
    Entladezeit des Kondensators an C1 durch die Stromsenke IC2 zwischen Kondensatorspannungswerten von
    z.B. 3,5V bis 4V und 3V. Da die Quittierung nicht
    synchron zu der am Kondensator zwischen 3,5V und 4V
    schwankenden Spannung einsetzt, beginnt die Konden-
    satorentladung bei irgendeinem Kondensatorspan-
    nungswert zwischen 3,5V und 4V. Die Ansprechverzögerung ist abgelaufen, wenn der Schmitt-Trigger
    SMT1 den Signalweg wieder freigibt, also z.B. 3V
    erreicht wurden (zuständig SMT1, SMT3).

5.  Abschaltverzögerung der Störungsmeldung am Ausgang
    SM1 nach störungsfreiem (gelungenem) Wiederzuschalten des Leistungsausgangs AC1. Gelingt die Wiederzuschaltung des Leistungsausgangs aufgrund Dauer-
    oder Handquittierung nach behobener Überlastung,
    geht der Ausgang SM1 kurz darauf wieder in den
    gesperrten Zustand über. (Die Störungsmeldung
    verschwindet.) Die Dauer der Verzögerung entspricht
    der Entladezeit des Kondensators durch die Stromsenke IC2 zwischen Kondensatorspannungswerten von
    z.B. 3V und 2,5V (zuständig SMT1 und SMT2).

Diese Verzögerungszeit ist bei induktiver Überlast
am Ausgang AC1 von besonderem Nutzen. Besteht z.B.
bei einem Wiederzuschaltversuch die induktive
Überlast noch, so läuft der Strom aufgrund der
Induktivität nach der Zuschaltung von Null hoch,
bis er schließlich zu groß wird und eine Überlastung darstellt. In der Zwischenzeit wird ein
fehlerfreier Fall vorgetäuscht. Normalerweise würde
hier die Störungsmeldung weggehen und dann wiederkehren. Durch die Verzögerung wird dies verhindert,

705/81          14      **0082493**

weil sie die Zeit des Stromhochlaufs bei induktiver Last überbrückt. Es liegt also auch in diesem Fall eine ununterbrochene Störungsmeldung vor.

Der zwischen SMT2 und Ausgang SM1 angeordnete Transistor T2 weist einen "Open-Collector-Ausgang" auf, wobei der Transistor im Störungsfall leitend wird.

A n s p r u c h

Ansteuerschaltung für kurzschlußfeste Ausgabestufen mit mehreren schutzbeschalteten Ein- und Ausgängen, dadurch gekennzeichnet, daß einem Signaleingang (I1) ein auf eine Referenzspannung ($U_{SCHW}$) bezogener erster Komparator (1) nachgeschaltet ist, der wiederum ein nachgeschaltetes erstes UND-Glied (4) ansteuert, das bei positiver Komparatorausgangsspannung durchgeschaltet ist,

daß das durchgeschaltete UND-Glied (4) einen vorher auf Minus-Potential gelegten Schalter (SW1) öffnet, wodurch eine an diesen Schalter (SW1) gelegte Stromquelle (IA3) nicht mehr auf Minus-Potential gelegt ist, sondern eine an Betriebsspannung ($U_S$) geführte erste steuerbare Stromquelle (IA1) die Versorgung einer nachgeschalteten Treiberstufe (T1) übernimmt,

daß zwischen die beiden Stromquellen (IA1 und IA3) die Basis einer Darlington-Stufe (T1) geschaltet ist, wobei der Kollektorausgang dieser Stufe auf einen Leistungsausgang (AC1) und der Emitter auf einen Spannungsversorgungsausgang (AE) gelegt ist, daß eine weitere steuerbare Stromquelle (IA2) parallel zur geschalteten Stromquelle (IA3) auf die Basis der Darlington-Stufe (T1) einwirkt,

daß die Stromquellen (IA1 und IA2) von einer Auswerteschaltung (8) angesteuert werden, die wiederum von einem Stromfühlereingang (S1) und einem Schwellspannungsausgang (RefS) beeinflußbar sind,

daß die Auswerteschaltung (8) ein ODER-Glied (7) derart beeinflußt, daß über eine Schalteinrichtung (SW2) eine Stromquelle (IC1) ladend oder eine Stromquelle (IC2) entladend auf einen an einer Eingangsklemme (C1) geschalteten externen Kondensator einwirkt,

daß die Kondensatorladung auf drei Schmitt-Trigger (SMT1,SMT2,SMT3) mit jeweils unterschiedlichen Schaltschwellen derart geführt ist, daß der Ausgang des ersten Schmitt-Triggers (SMT1) auf einen Eingang des UND-Gliedes (4), auf den einen Eingang eines zweiten UND-Gliedes (5) und auf den Setzeingang des zweiten Schmitt-Triggers (SMT2) gelegt ist, daß ferner der Ausgang des dritten Schmitt-Triggers (SMT3) auf einen anderen Eingang des zweiten UND-Gliedes (5) gelegt ist und daß der Ausgang des zweiten Schmitt-Triggers (SMT2) über eine Transistorstufe (T2) auf einen Störmeldeausgang (SM1) geführt ist,

daß an einen Quittiereingang (R) ein ebenfalls auf Referenzspannung (U$_{Schw}$) bezogener zweiter Komparator (2) angeschaltet ist, und daß der Ausgang dieses Komparators (2) mit einem weiteren Eingang des zweiten UND-Gliedes (5) verbunden ist,

daß an einem Eingang (In) ein ebenfalls auf Referenzspannung (U$_{Schw}$) bezogener dritter Komparator (3) angeschaltet ist, dessen Ausgang auf einen weiteren Eingang des ersten UND-Gliedes (4) geführt ist und daß der Ausgang des zweiten UND-Gliedes (5) ebenfalls auf das ODER-Glied (7) einwirkt und damit den externen Kondensator ladend oder entladend steuert.

0082493